Europäisches Patentamt

European Patent Office

Office européen des brevets

Publication number: **0 293 111**
**A2**

# EUROPEAN PATENT APPLICATION

21 Application number: 88304349.9

51 Int. Cl.4: **H03M 1/14**

22 Date of filing: 13.05.88

30 Priority: 23.05.87 GB 8712263

43 Date of publication of application:
30.11.88 Bulletin 88/48

84 Designated Contracting States:
AT BE CH DE ES FR GB GR IT LI LU NL SE

71 Applicant: **DATA CONVERSION SYSTEMS LIMITED**
**Sheraton House Castle Park**
**Cambridge, CB3 0AX(GB)**

72 Inventor: **Webber, Andrew Mark**
**15 Museum Street**
**Saffron Walden Essex(GB)**

74 Representative: **Nash, Keith Wilfrid et al**
**KEITH W. NASH & Co. Pearl Assurance**
**House 90-92 Regent Street**
**Cambridge CB2 1DP(GB)**

54 Improvements in analogue to digital converters.

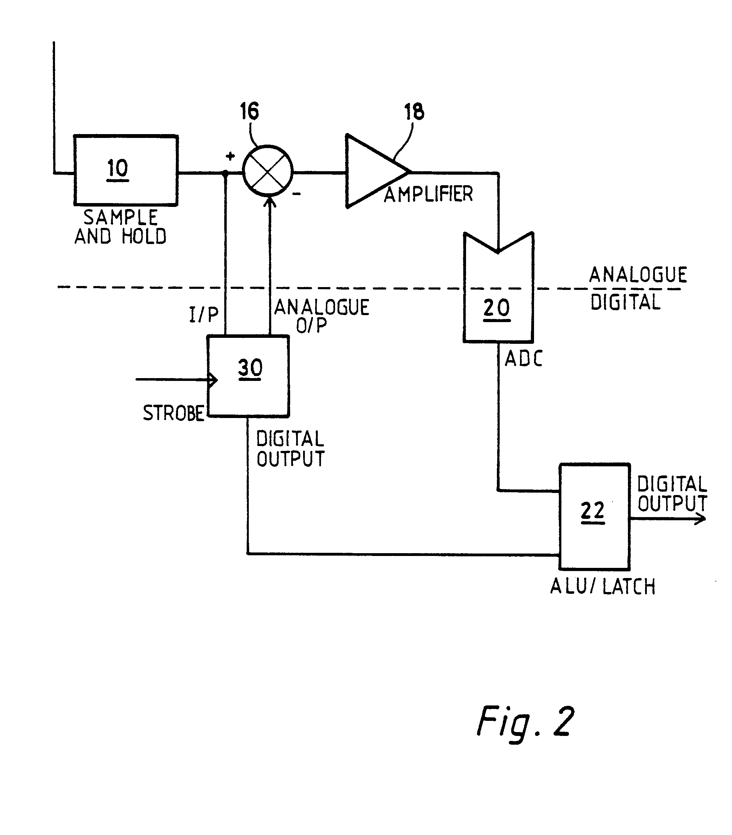

57 An A/D converter comprises a sample-and-hold circuit (10) receiving the analogue input and a clocked circuit (30) also receiving said analogue input or a derivative thereof and providing an analogue feedback to a difference signal circuit (16) and a digital output to an encoding circuit (22) which also receives a digital output from a flash converter (20) fed with the amplified output of the difference signal circuit (Figure 2).

EP 0 293 111 A2

## Improvements in Analogue to Digital Converters

### Field of the invention

This invention relates to an analogue to digital converter (ADC).

### Background to the invention

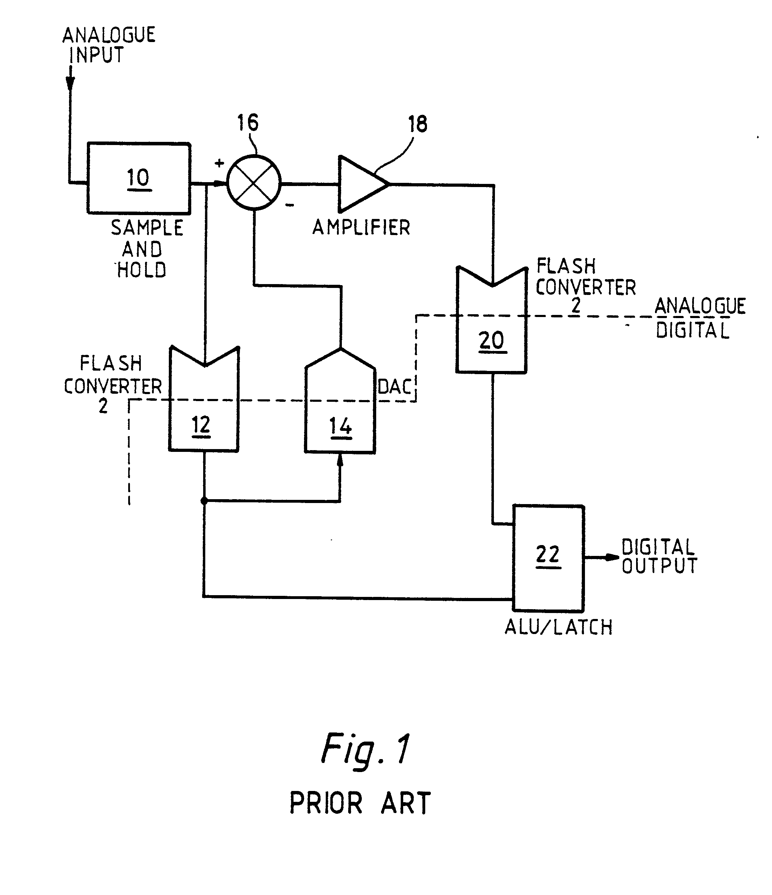

Making reference to Figure 1 of the accompanying drawings, a known analogue to digital converter includes a sample-and-hold circuit 10 the output of which remains constant for the duration of the conversion. A first flash converter 12 is employed to make an estimate of the sample-and-hold circuit output, and an accurate analogue representation of this output is formed by a precision DAC 14. This analogue representation is subtracted at circuit 16 from the sample-and-hold circuit output, and the difference signal is amplified at 18 and digitized by a second flash converter 20. The digital outputs of the two flash converters 12 and 20 are combined at a digital encoding circit 22 to provide a digital output which constitutes the final result of the conversion.

This known ADC is able to provide a more accurate degree of conversion than a simple flash converter, but has the disadvantage that the speed of conversion is substantially reduced.

Three factors, in particular, contribute to this loss of speed. Two of these are the sample-and-hold circuit acquisition time and the settling time of the amplifier, respectively due to the finite bandwidths of these circuits. The third factor is the time taken for the first conversion and DAC set-up, primarily due to propagation delays through the first flash converter and the DAC.

It is possible to reduce the last-mentioned delays by "pipe-lining" the output of the sample-and-hold circuit, but such a modification increases power consumption and in general renders the ADC unsuitable for integrated circuit designs.

It is a primary object of this invention to provide an improved analogue to digital converter which allows faster conversion than the above-described known converter, but with at least equal accuracy, and at the same time provide a fast and accurate ADC which is suitable for miniaturisation and integrated circuit design.

### The invention

According to the invention, an analogue to digital converter comprises a sample-and-hold circuit receiving the analogue input to be converted, a difference signal circuit and a clocked circuit receiving an analogue signal from the input side or the output side of the sample-and-hold circuit output, the clocked circuit providing an analogue feedback to the difference signal circuit and also providing a digital output to an encoding circuit at which the said digital output is combined with a second digital output received from a flash converter receiving the amplified output of the difference signal circuit, thereby to provide the required final digital output, wherein the clocked circuit is a circuit which provides a quantised analogue output proportional to the output of the sample-and-hold circuit and, when activated by a clock input, acts to freeze this quantised analogue output and provide a digital output proportional thereto for supply to the encoding circuit.

Essentially, therefore, the present invention resides in replacement of the first flash converter and precision DAC of the known circuit by the said clocked circuit, with advantages in respect of speed of analogue/digital conversion which will be explained hereinafter.

A preferred clocked circuit comprises, for each of a plurality of quantisation levels, a comparator having a reference voltage input, and a latch circuit receiving the output of the comparator, having a clock input, and providing a digital output fed to the encoding circuit and also fed to a switched current source providing the analogue feedback.

### Brief description of drawings

The analogue to digital converter in accordance with the invention is exemplified in the accompanying drawings, in which:-

Figure 1 is a circuit diagram of a known ADC;

Figure 2 is a circuit diagram of an ADC in accordance with the invention; and

Figure 3 is a circuit diagram of one practical arrangement of clocked circuit employed in the ADC of the invention.

## Description of embodiment

The known ADC of Figure 1 has been previously described. Referring to Figure 2, wherein the same references as in Figure 1 are employed for corresponding components, it can be seen that, in the ADC in accordance with the invention, the first flash converter 12 and precision DAC 14 of Figure 1 are replaced by a clocked circuit 30.

The clocked circuit 30 is arranged to provide a quantised analogue output 32 proportional to the output of the sample-and-hold circuit 10 and, when clocked , freeze this analogue output and, with only a minimal delay, provide a digital output 34 proportional thereto for the encoding circuit. The analogue output 32 is fed back to the difference signal circuit 16.

In a modification, the clocked circuit is fed from the input side of the sample-and-hold circuit 10 instead of its output side.

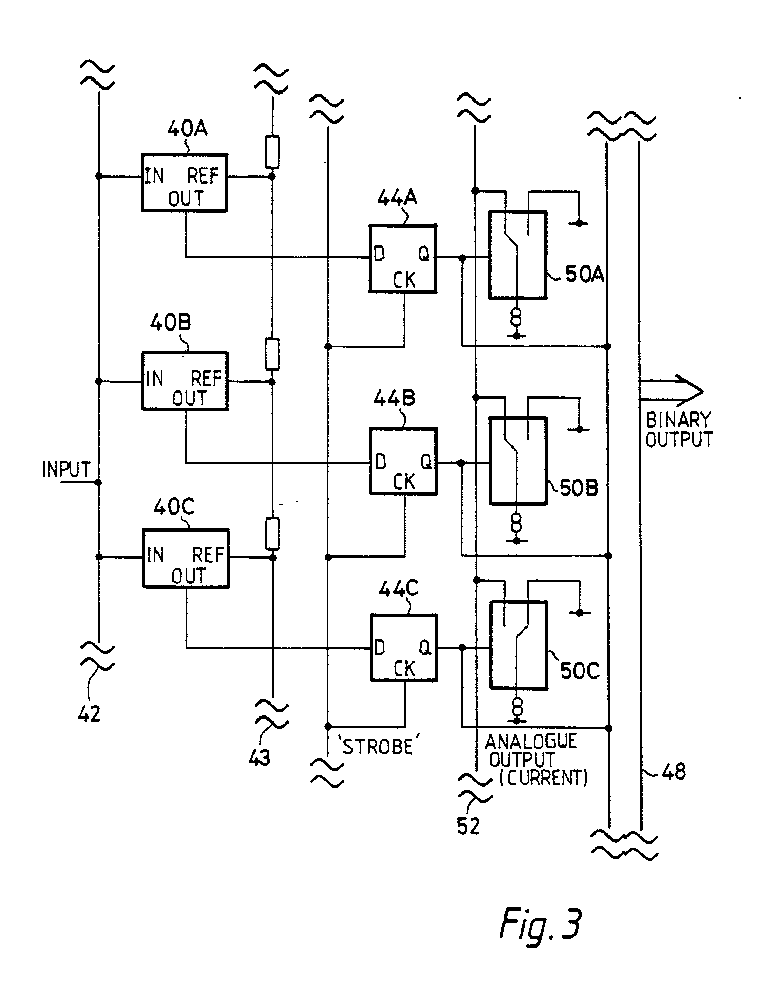

Figure 3 shows a practical arrangement of the clocked circuit 30. The arrangement as illustrated is for three quantisation levels, but this is by way of example only. Each quantisation level comprises a comparator fed with the analogue input 42. The three comparators 40A, 40B, 40C have reference voltage inputs provided by a resistor chain 43, in analogous manner to a flash converter. Each comparator provides an output to a circuit 44A, 44B or 44C in the form of a transparent latch having a clock input 46. Each clocked latch 44A or 44B or 44C provides a digital output to a digital coder analogous to that employed in the prior art and generally referenced 48. In addition, each clocked latch 44A or 44B or 44C supplies the digital output to a switched current source 50A or 50B or 50C, these providing the analogue feedback 52 to the difference signal circuit of Figure 2.

The ADC in accordance with the invention has the following advantages in use:-

1. The comparator outputs are encoded while the amplifier is settling, so that encoding time does not add to the total conversion time. (In the circuit of Figure 1 the analogue output is not available until encoding has been completed.)

2. The analogue output is constantly updated while the sample-and-hold circuit is acquiring, and this avoids the problem of limiting at the amplifier output.

3. As the time available for encoding the comparator is greater than with a flash converter, possible errors caused by metastable states in the latch can be substantially eliminated.

4. The preferred use of equally weighted current sources, rather than a small number of binary weighted sources, relaxes the requirements for accuracy of each source individually, which is of particular importance for an integrated circuit design.

5. The possibility for further speed improvement is available if the strobed circuit 30 (Figure 2) is fed from the input side of the sample-and-hold circuit instead of the output side. This possibility is dependent on controlling certain performance parameters of the sample- and-hold circuit.

It will be appreciated that the above-described and illustrated arrangement may be modified in various ways within the scope of the invention hereinbefore defined.

## Claims

1. An analogue to digital converter comprising a sample-and-hold circuit receiving an analogue input to be converted, a difference signal circuit and a clocked circuit receiving an analogue signal from the input side or the output side of the sample-and-hold circuit output, the clocked circuit providing an analogue feedback to the difference signal circuit and also providing a digital output to an encoding circuit at which the said digital output is combined with a second digital output received from a flash converter receiving the amplified output of the difference signal circuit, thereby to provide the required final digital output, wherein the clocked circuit is a circuit which provides a quantised analogue output proportional to the output of the sample-and-hold circuit and, when activated by a clock input, acts to freeze this quantised analogue output and provide a digital output proportional thereto for supply to the encoding circuit.

2. An A/D converted according to claim 1, wherein the clocked circuit comprises a comparator having a reference voltage input, and a latch circuit receiving the output of the comparator, having a clock input, and providing a digital output fed to the encoding circuit.

3. An A/D converter according to claim 2, wherein a similar clocked circuit is provided for each of a plurality of quantisation levels.

4. An A/D converter according to claim 3, wherein the comparators have reference voltage inputs, different for each quantisation level, derived from a resistor chain.

5. An A/D converter according to any of claims 2 to 4, wherein the digital output of the or each latch circuit is fed to a switched current source to provide the analogue feedback.

6. An A/D converer according to any of claims 2 to 5, wherein the or each latch circuit provides its digital output to a digital coder.

7. An A/D converter substantially as herebefore described with reference to Figure 2 or Figure 3 of the accompanying drawings.

*Fig.1*

PRIOR ART

Fig. 2

*Fig. 3*